# EUROPEAN PATENT APPLICATION

(11) **EP 2 273 563 A2**
(43) Date of publication of application: **12.01.2011**
(21) Application number: 10160268.8
(22) Date of filing: 19.04.2010
(51) Int. Cl.: H01L 31/075, H01L 31/18, H01L 31/0368, H01L 31/0376

(54) **Photovoltaic device and manufacturing method thereof**

(30) Priority: 07.07.2009 KR 20090061681
(71) Applicant: KISCO, Changwon-si Gyeongsangnam-do 641-370 (KR)
(72) Inventor: Myong, Seung-Yeop, 156-831, Seoul (KR)
(74) Representative: Ferreccio, Rinaldo

(57) **Abstract**

Disclosed is a photovoltaic device. The photovoltaic device includes:
a substrate;
a first electrode disposed on the substrate;
at least one photoelectric transformation layer disposed on the first electrode, the photoelectric transformation layer including a light absorbing layer; and
a second electrode disposed on the photoelectric transformation layer,
wherein the light absorbing layer includes the first sub-layer and the second sub-layer, the first sub-layer including hydrogenated micro-crystalline silicon germanium (µc-SiGe:H) and an amorphous silicon germanium network (a-SiGe:H) formed among the hydrogenated micro-crystalline silicon germaniums, the second sub-layer including hydrogenated micro-crystalline silicon (µc-Si:H) and an amorphous silicon network (a-Si:H) formed among the hydrogenated micro-crystalline silicons.

## Description

### BACKGROUND

### Field of application

This application relates to a photovoltaic device and a manufacturing method thereof.

### Description of the Related Art

Recently, as existing energy sources such as oil and charcoal and so on are expected to be exhausted, attention is now paid to alternative energy sources which can be used in place of the existing energy sources. Among the alternative energy sources, sunlight energy is abundant and has no environmental pollution. For this reason, more and more attention is paid to the sunlight energy.

A photovoltaic device, that is to say, a solar cell converts directly sunlight energy into electrical energy. The photovoltaic device uses mainly photovoltaic effect of semiconductor junction. In other words, when light is incident and absorbed to a semiconductor pin junction formed through a doping process by means of p-type and n-type impurities respectively, light energy generates electrons and holes at the inside of the semiconductor. Then, the electrons and the holes are separated by an internal field so that a photo-electro motive force is generated at both ends of the pin junction. Here, if electrodes are formed at the both ends of junction and connected with wires, an electric current flows externally through the electrodes and the wires.

In order that the existing energy sources such as oil is substituted with the sunlight energy source, it is required that a degradation rate of the photovoltaic device should be low and a stability efficiency of the photovoltaic device should be high, which are produced by the elapse of time.

### SUMMARY

One aspect of this invention includes a photovoltaic device. The photovoltaic device includes:
a substrate;
a first electrode disposed on the substrate;
at least one photoelectric transformation layer disposed on the first electrode, the photoelectric transformation layer including a light absorbing layer; and
a second electrode disposed on the photoelectric transformation layer,
wherein the light absorbing layer includes the first sub-layer 233-2A and the second sub-layer 233-2B, the first sub-layer 233-2A including hydrogenated micro-crystalline silicon germanium (µc-SiGe:H) and an amorphous silicon germanium network (a-SiGe:H) formed among the hydrogenated micro-crystalline silicon germaniums, the second sub-layer 233-2B including hydrogenated micro-crystalline silicon (µc-Si:H) and an amorphous silicon network (a-Si:H) formed among the hydrogenated micro-crystalline silicons.

Another aspect of this invention includes a photovoltaic device. The photovoltaic device includes::
a substrate;
a first electrode disposed on the substrate;
a first photoelectric transformation layer disposed on the first electrode, the first photoelectric transformation layer including a light absorbing layer, and a second photoelectric transformation layer disposed on the first photoelectric transformation layer, the second photoelectric transformation layer including the light absorbing layer; and
a second electrode disposed on the second photoelectric transformation layer,
wherein the light absorbing layer includes the first sub-layer 233-2A and the second sub-layer 233-2B, the first sub-layer 233-2A including hydrogenated micro-crystalline silicon germanium (µc-SiGe:H) and an amorphous silicon germanium network (a-SiGe:H) formed among the hydrogenated micro-crystalline silicon germaniums, the second sub-layer 233-2B including hydrogenated micro-crystalline silicon (µc-Si:H) and an amorphous silicon network (a-Si:H) formed among the hydrogenated micro-crystalline silicons.

One aspect of this invention includes a method of manufacturing a photovoltaic device. The method includes:
forming a first electrode on a substrate;
forming at least one photoelectric transformation layer on the first electrode in a chamber, the photoelectric transformation layer including a light absorbing layer;
forming a second electrode on the photoelectric transformation layer;
wherein flow rates of silane which are supplied to the chamber are constant while the light absorbing layer is formed; and
wherein a flow rate of source gas including non-silicon based material varies alternately within a range between a first flow rate value and a second flow rate value in accordance with an elapse of a deposition time; and
wherein a flow rate of hydrogen flown to the chamber at a first point of time is greater than a flow rate of the hydrogen at a second point of time posterior to the first point of time; and
wherein the first flow rate value increases in accordance with an elapse of a deposition time; and
wherein first sub-layers and second sub-layers of the light absorbing layer are formed far from a side of incident light, the first sub-layers and the second sub-layers being formed in accordance with the first flow rate value and the second flow rate value.

Another aspect of this invention includes a method of manufacturing a photovoltaic device. The method includes:
forming a first electrode on a substrate;
forming at least one photoelectric transformation layer on the first electrode in a chamber, the photoelectric transformation layer including a light absorbing layer;
forming a second electrode on the photoelectric transformation layer;
wherein flow rates of silane which are supplied to the chamber are constant while the light absorbing layer is formed; and
wherein a flow rate of source gas including non-silicon based material varies alternately within a range between a first flow rate value and a second flow rate value in accordance with an elapse of a deposition time; and
wherein a flow rate of hydrogen flown to the chamber at a first point of time is greater than a flow rate of the hydrogen at a second point of time posterior to the first point of time; and
wherein a duration time of the first flow rate value increases in accordance with an elapse of a deposition time; and
wherein first sub-layers and second sub-layers of the light absorbing layer are formed far from a side of incident light, the first sub-layers and the second sub-layers being formed in accordance with the first flow rate value and the second flow rate value.

### BRIEF DESCRIPTION OF THE DRAWINGS

The embodiment will be described in detail with reference to the following drawings.
Fig. 1 shows a photovoltaic device according to a first embodiment of the present invention.
Fig. 2 shows another photovoltaic device according to a second embodiment of the present invention.
Figs. 3A to 3H show a manufacturing method of a photovoltaic device according to an embodiment of the present invention.
Fig. 4 shows a plasma-enhanced chemical vapor deposition apparatus for forming a light absorbing layer according to an embodiment of the present invention.
Figs. 5A to 5F show a variation of flow rate of source gas for forming a light absorbing layer according to an embodiment of the present invention.
Fig. 6 shows a light absorbing layer including a plurality of sub-layers included in an embodiment of the present invention.

### DETAILED DESCRIPTION OF EMBODIMENTS

Embodiments will be described in a more detailed manner with reference to the drawings.

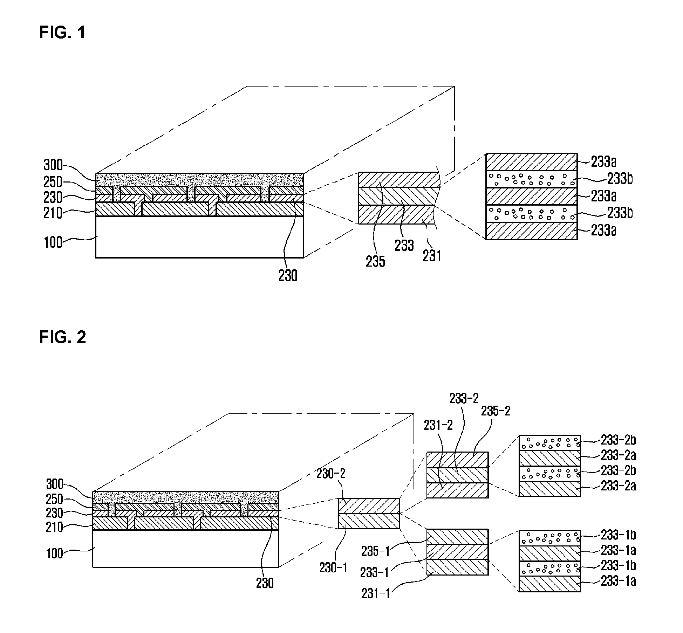

Fig. 1 shows a photovoltaic device according to a first embodiment of the present invention.

As shown, a photovoltaic device includes a substrate 100, a first electrode 210, a second electrode 250, a photoelectric transformation layer 230 and a protecting layer 300.

In detail, the first electrodes 210 are disposed on the substrate 100. The first electrodes 210 are spaced from each other at a regular interval in such a manner that adjacent first electrodes are not electrically short-circuited. The photoelectric transformation layer 230 is disposed on the first electrode 210 in such a manner as to cover the area spaced between the first electrodes at a regular interval. The second electrodes 250 are disposed on the photoelectric transformation layer 230 and spaced from each other at a regular interval in such a manner that adjacent second electrodes are not electrically short-circuited. In this case, the second electrode 250 penetrates the photoelectric transformation layer and is electrically connected to the first electrode 210 such that the second electrode 250 is connected in series to the first electrode 210. The adjacent photoelectric transformation layers 230 are spaced at the same interval as the interval between the second electrodes. The protecting layer 300 is disposed on the second electrode in such a manner as to cover the area spaced between the second electrodes and the area spaced between the photoelectric transformation layers.

The photoelectric transformation layer 230 includes a p-type semiconductor layer 231, a light absorbing layer 233 and an n-type semiconductor layer 235. The light absorbing layer 233 includes a first sub-layer 233A and a second sub-layer 233B stacked on the first sub-layer 233A. The first sub-layer 233A includes hydrogenated micro-crystalline silicon germanium (µc-SiGe:H) and an amorphous silicon germanium network (a-SiGe:H) formed among the hydrogenated micro-crystalline silicon germaniums. The second sub-layer 233B includes hydrogenated micro-crystalline silicon (µc-Si:H) and an amorphous silicon network (a-Si:H) formed among the hydrogenated micro-crystalline silicons. The amorphous silicon germanium network included in the first sub-layer and the amorphous silicon network included in the second sub-layer include a crystalline silicon grain respectively.

Fig. 2 shows another photovoltaic device according to a second embodiment of the present invention.

Since a photovoltaic device of Fig. 2 is almost similar to that of Fig.1, descriptions of the same structure will be omitted. In Fig. 2, the photoelectric transformation layer 230 includes a first photoelectric transformation layer 230-1 and a second photoelectric transformation layer 230-2 disposed on the first photoelectric transformation layer. The first photoelectric transformation layer and the second photoelectric transformation layer include p-type semiconductor layers 231-1 and 231-2, light absorbing layers 233-1 and 233-2 and n-type semiconductor layers 235-1 and 235-2.

The light absorbing layers 233-1 and 233-2 include first sub-layers 233-1A and 233-2A and second sub-layers 233-1B and 233-2B stacked on the first sub-layers. Here, the light absorbing layer 233-1 included in the first photoelectric transformation layer 230-1 includes the first sub-layer 233-1A and the second sub-layer 233-1B. The first sub-layer 233-1A includes the hydrogenated amorphous silicon based material and the second sub-layer 233-1B includes the hydrogenated amorphous silicon based material and a crystalline silicon grain surrounded by the hydrogenated amorphous silicon based material. The light absorbing layer 233-2 included in the second photoelectric transformation layer 230-2 includes the first sub-layer 233-2A and the second sub-layer 233-2B. The first sub-layer 233-2A includes hydrogenated micro-crystalline silicon germanium (µc-SiGe:H) and an amorphous silicon germanium network (a-SiGe:H) formed among the hydrogenated micro-crystalline silicon germaniums. The second sub-layer 233-2B includes hydrogenated micro-crystalline silicon (µc-Si:H) and an amorphous silicon network (a-Si:H) formed among the hydrogenated micro-crystalline silicons. Here, the amorphous silicon germanium network included in the first sub-layer and the amorphous silicon network included in the second sub-layer include a crystalline silicon grain respectively.

While only two photoelectric transformation layers are provided in the present embodiment, three or more photoelectric transformation layers can be also provided. Regarding a second photoelectric transformation layer or a third photoelectric transformation layer among three photoelectric transformation layers, which is far from a side of incident light, the second photoelectric transformation layer or the third photoelectric transformation layer is the same as the aforementioned second photoelectric transformation layer.

With respect to such photovoltaic devices according to the first and the second embodiments, a manufacturing method of the photovoltaic device will be described below in more detail.

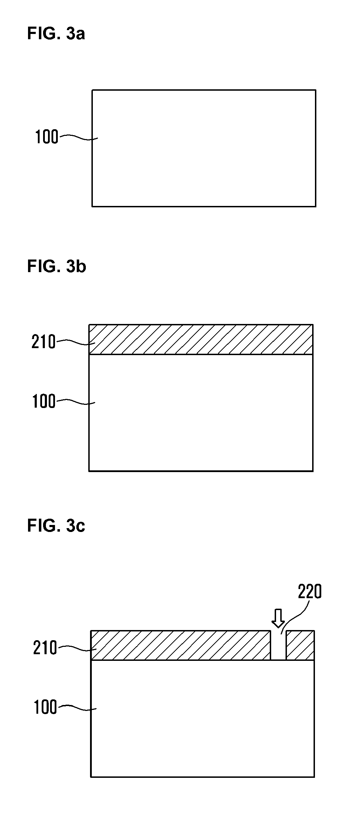

Figs. 3A to 3H show a manufacturing method of a photovoltaic device according to an embodiment of the present invention.

As shown in Fig. 3A, a substrate 100 is provided first. An insulating transparent substrate 100 can be used as the substrate 100.

As shown in Fig. 3B, a first electrode 210 is formed on the substrate 100. In the embodiment of the present invention, the first electrode 210 can be made by chemical vapor deposition (CVD) or be made of transparent conductive oxide (TCO) such as SnO₂ or ZnO.

As shown in Fig. 3C, a laser beam is irradiated onto the first electrode 210 or the substrate 100 so that the first electrode 210 is partially removed. As a result, a first separation groove 220 is formed. That is, since the separation groove 210 penetrates the first electrode 210, preventing adjacent first electrodes from being short-circuited.

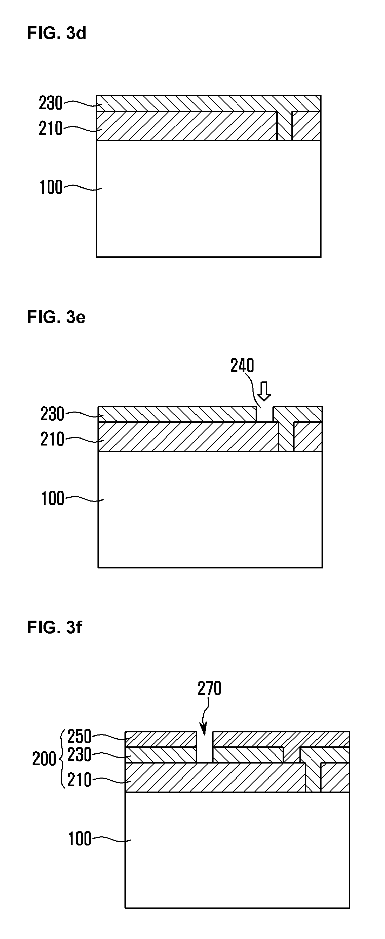

As shown in Fig. 3D, at least one photoelectric transformation layer 230 including a light absorbing layer is stacked by CVD in such a manner as to cover the first electrode 210 and the first separation groove 220. In this case, each photoelectric transformation layer 230 includes a p-type semiconductor layer, a light absorbing layer and an n-type semiconductor layer. In order to form the p-type semiconductor layer, source gas including silicon, for example, SiH₄ and source gas including group 3 elements, for example, B₂H₆ are mixed in a reaction chamber, and then the p-type semiconductor layer is formed by CVD. Then, the source gas including silicon is flown to the reaction chamber so that the light absorbing layer is formed on the p-type semiconductor layer by CVD. A method of manufacturing the light absorbing layer will be described later in detail. Finally, reaction gas including group 5 element, for example, PH₃ and source gas including silicon are mixed, and then the n-type semiconductor layer is stacked on an intrinsic semiconductor by CVD. Accordingly, the p-type semiconductor layer, the light absorbing layer and the n-type semiconductor layer are stacked on the first electrode 210 in order specified.

The light absorbing layer according to the embodiment of the present invention can be included in a single junction photovoltaic device including one photoelectric transformation layer 230 or in a multiple junction photovoltaic device including a plurality of photoelectric transformation layers.

As shown in Fig. 3E, a laser beam is irradiated from the air onto the substrate 100 or the photoelectric transformation layer 230 so that the photoelectric transformation layer 230 is partially removed. A second separation groove 240 is hereby formed in the photoelectric transformation layer 230.

As shown in Fig. 3F, the second electrode 250 is formed by CVD or sputtering process to cover the photoelectric transformation layer 230 and the second separation groove 240. A metal layer made of A1 or Ag can be used as the second electrode 250.

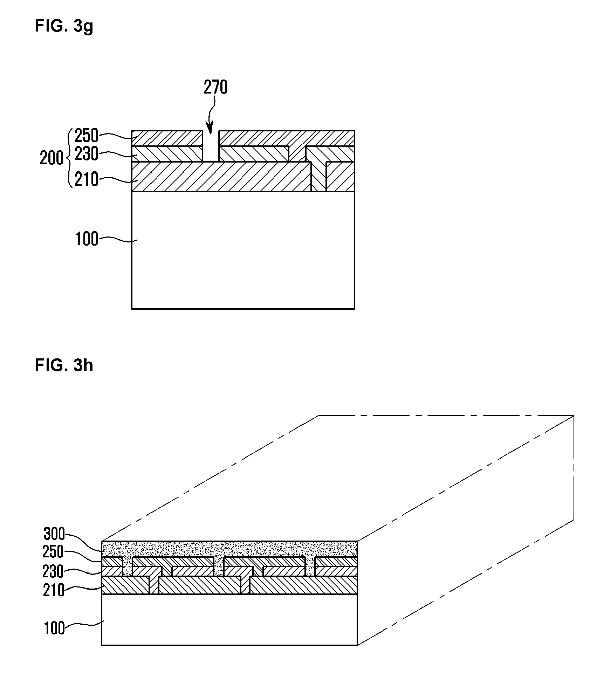

As shown in Fig. 3G, a laser beam is irradiated from the air onto the substrate 100 so that the photoelectric transformation layer 230 and the second electrode 250 are partially removed. As a result, a third separation groove 270 is formed in the photo voltaic layer 230 and the second electrode 250.

As shown in Fig. 3H, through lamination process, a protecting layer 300 covers partially or entirely a photovoltaic cell 200 including the photoelectric transformation layer 230, the first electrode 210 and the second electrode 250 so as to protect the photovoltaic cell 200. The protecting layer 300 can include ethylene Vinyl Acetate (EVA).

Through such a process, provided is the photoelectric transformation layer 200 having the protecting layer 300 formed thereon. A backsheet (not shown) can be made on the protecting layer.

In the next place, a manufacturing method of the light absorbing layer will be described in detail with reference to figures.

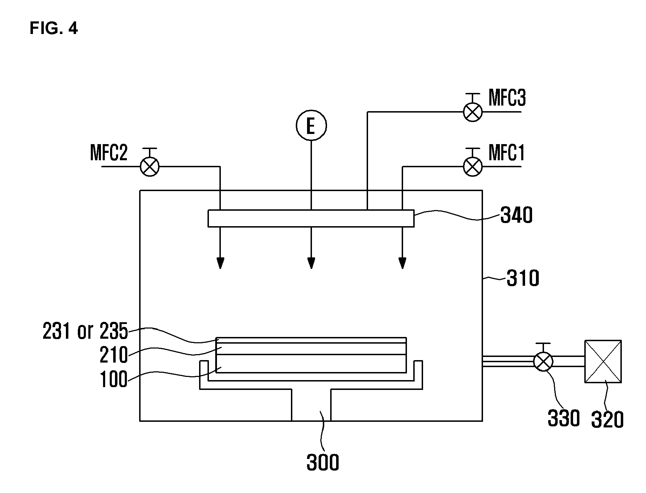

Fig. 4 shows a plasma-enhanced chemical vapor deposition apparatus for forming a light absorbing layer according to an embodiment of the present invention. As shown in Fig. 4, the first electrode 210, the p-type semiconductor layer 231 or the n-type semiconductor layer 235 are formed on the substrate 100. The substrate 100 is disposed on a plate 300 functioning as an electrode. A vacuum pump 320 operates in order to remove impurities in a chamber 310 before the light absorbing layer forming process. As a result, the impurities in the chamber 310 are removed through an angle valve 330 so that the inside of the chamber 310 is actually in a vacuum state.

When the inside of the chamber 310 is actually in a vacuum state, source gas such as hydrogen (H₂) and silane (SiH₄) and source gas including non-silicon based material such as germanium are flown to the inside of the chamber 310 through mass flow controllers MFC1, MFC2 and MFC3 and an electrode 340 having a nozzle formed therein.

In other words, the hydrogen can be flown to the chamber through a first mass flow controller MFC 1. The silane can be flown to the chamber through a second mass flow controller MFC2. The non-silicon based material such as germanium can be flown to the chamber through a third mass flow controller MFC3.

Here, the angle valve 330 is controlled to maintain the pressure of the chamber 310 constant. When the pressure of the chamber 310 is maintained constant, silicon powder caused by a vortex created in the chamber 310 can be prevented from being generated and deposition condition can be maintained constant. The hydrogen is flown to the chamber in order to dilute the silane and reduces Staebler-Wronski effect.

When the source gases are flown to the chamber and a voltage from an electric power source E is supplied to the electrode, an electric potential difference is generated between the electrode 340 and the plate 300. As a result, the source gas is in a plasma state, and the light absorbing layer is deposited on the p-type semiconductor layer 231 or the n-type semiconductor layer 235.

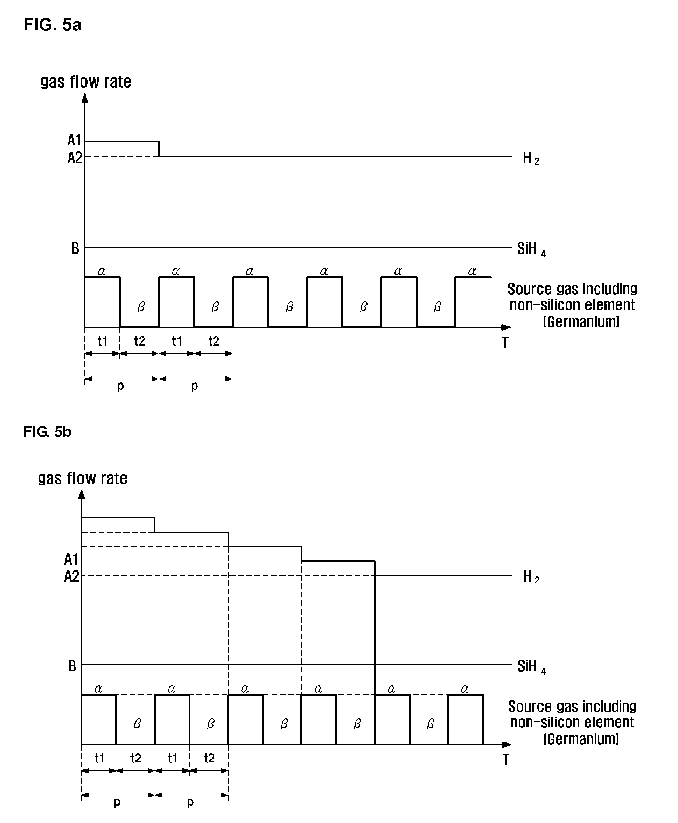

Figs. 5A to 5F show a variation of flow rate of source gas for forming a light absorbing layer according to an embodiment of the present invention.

As shown in Figs. 5A to 5C, a flow rate of source gas including non-silicon based material such as germanium varies alternately within a range between a first flow rate value α and a second flow rate value β in accordance with the elapse of a deposition time T. In this case, the first flow rate value α and the second flow rate value β are constant. The first flow rate value α is greater than the second flow rate value β, and the second flow rate value β has a value of 0.

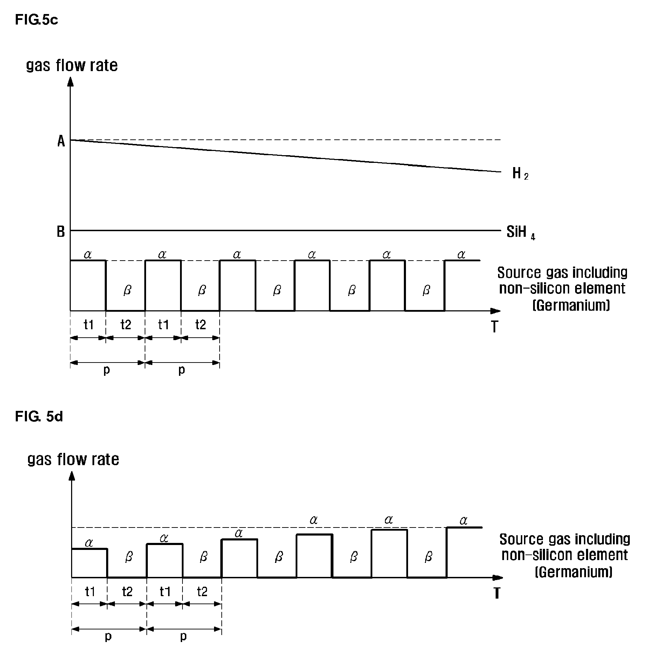

Here, a flow rate of hydrogen at a first point of time is greater than that of the hydrogen at a second point of time posterior to the first point of time. Such a reduction pattern of the hydrogen flow rate can be variously formed. For example, as shown in Fig. 5A, a flow rate A1 of the hydrogen, which is supplied during at least one cycle P derived from a sum of a duration time of the first flow rate value α and a duration time of the second flow rate value β from a starting point of time for depositing the light absorbing layer, is greater than a flow rate A2 of the hydrogen which is supplied after the at least one cycle P. As shown in Fig. 5B, for each cycle P, flow rates A1, A2, A3 and so on of the hydrogen can be reduced in accordance with the elapse of the deposition time T from a starting point of time for depositing the light absorbing layer. As shown in Fig. 5C, the flow rate of the hydrogen can be gradually reduced in accordance with the elapse of the deposition time T.

Such a variation of the flow rate of the hydrogen will be described later in detail.

In Figs. 5A to 5C, the flow rate of the hydrogen varies and the first flow rate value α and the second flow rate value β of the source gas including non-silicon based material are constant. On the other hand, as shown in Figs. 5D to 5F, while the flow rate of the hydrogen is reduced as shown in Figs. 5A to 5C, the first flow rate value α of the source gas including non-silicon based material can be increased or a duration time t1 of the first flow rate value α can be increased.

That is to say, in Figs. 5D to 5F, a supply pattern of the source gas including non-silicon based material can be applied to one of the patterns of the hydrogen flow rate variation shown in Figs. 5A to 5C. For example, as shown in Fig. 5A, the flow rate of the hydrogen varies and the source gas including non-silicon based material can be supplied in accordance with one of supply patterns, which are shown in Figs. 5D to 5F, of the source gas including non-silicon based material.

As shown in Fig. 5D, the flow rate of the source gas including non-silicon based material varies alternately within a range between the first flow rate value α and the second flow rate value β (that is, which is equal to 0) in accordance with the elapse of the deposition time T. The first flow rate value α is increased in accordance with the elapse of the deposition time T.

In this case, the duration time t1 of the first flow rate value α and a duration time t2 of the second flow rate value β are constant in accordance with the elapse of the deposition time T during the one cycle P derived from a sum of a duration time of the first flow rate value α and a duration time of the second flow rate value β.

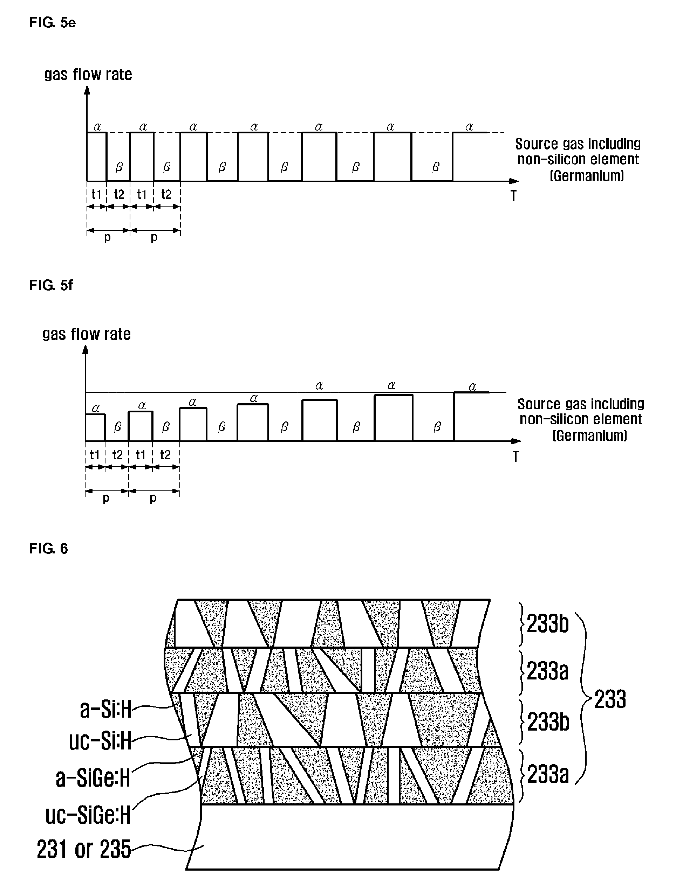

As shown in Fig. 5E, the flow rate of the source gas including non-silicon based material varies alternately within a range between the first flow rate value α and the second flow rate value β (that is, which is equal to 0) in accordance with the elapse of the deposition time T. The duration time t1 of the first flow rate value α is increased in accordance with the elapse of the deposition time T during the one cycle P derived from a sum of a duration time of the first flow rate value α and a duration time of the second flow rate value β.

In this case, the first flow rate value α and the second flow rate value β are constant in accordance with the elapse of the deposition time T. A ratio of the duration time t1 of the first flow rate value α to the duration time t2 of the second flow rate value β are constant in accordance with the elapse of the deposition time T during the one cycle P derived from a sum of a duration time of the first flow rate value α and a duration time of the second flow rate value β.

As shown in Fig. 5F, the flow rate of the source gas including non-silicon based material varies alternately within a range between the first flow rate value α and the second flow rate value β in accordance with the elapse of the deposition time T. Here, the duration time t1 of the first flow rate value α is increased in accordance with the elapse of the deposition time T during the one cycle P derived from a sum of a duration time of the first flow rate value α and a duration time of the second flow rate value β. The first flow rate value α is increased in accordance with the elapse of the deposition time T.

A ratio of the duration time t1 of the first flow rate value α to the duration time t2 of the second flow rate value β are constant in accordance with the elapse of the deposition time T during the one cycle P derived from a sum of a duration time of the first flow rate value α and a duration time of the second flow rate value β.

When the flow rate of the source gas including non-silicon based material such as germanium alternately corresponds to either the first flow rate value α or the second flow rate value β (that is, which is equal to 0), the light absorbing layer 233 is formed on the p-type semiconductor layer 231 or the n-type semiconductor layer 235. The light absorbing layer 233 includes a plurality of the sub-layers 233A and 233B. That is, the higher the flow rate of the source gas including non-silicon based material increases, the lower a crystalline and a deposition rate are. The lower the flow rate of the source gas including non-silicon based material decreases, the higher the crystalline and the deposition rate are.

Accordingly, since the source gas including non-silicon based material is not supplied during the duration time of the second flow rate value, the second sub-layer 233B is made of hydrogenated micro-crystalline silicon (µc-Si:H). Here, an amorphous silicon network (a-Si:H) including crystalline silicon grains is formed among the hydrogenated micro-crystalline silicons of the second sub-layer 233B.

Additionally, since the source gas including non-silicon based material is supplied, the first sub-layer 233A can be formed of hydrogenated micro-crystalline silicon (µc-SiGe:H). An amorphous silicon germanium network (a-SiGe:H) including crystalline silicon grains is formed with the hydrogenated micro-crystalline silicon germaniums of the first sub-layer 233A..

Here, if a hydrogen dilution ratio is equal to or more than a standard value, a micro-crystalline silicon phase such as micro-crystalline silicon germanium or micro-crystalline silicon can be formed instead of hydrogenated amorphous silicon phase. Since the first and the second sub-layers 233A and 233B have small optical band gaps, the first and the second sub-layers 233A and 233B can easily absorb light with a long wavelength.

Accordingly, the light absorbing layer of the bottom cell of the double or triple junction photovoltaic device can include both the second sub-layer 233B made of hydrogenated micro-crystalline silicon and the first sub-layer 233A made of hydrogenated micro-crystalline silicon germanium.

As such, when the light absorbing layer 233 including a plurality of the sub-layers 233A and 233B is made, the degradation rate, i.e., a difference between an initial efficiency and a stabilization efficiency, is reduced. Accordingly, the photovoltaic device according to the embodiment of the present invention can have a high stabilization efficiency.

That is, as compared with a light absorbing layer consisting of only the hydrogenated micro-crystalline silicon germanium (µc-SiGe:H), the degradation of the light absorbing layer 233 is rapid and the stabilization efficiency is increased because the first sub-layer 233A and the second sub-layer 233B are alternately formed as described in the embodiment of the present invention and because the amorphous silicon germanium network (a-SiGe:H) of the first sub-layer 233A and the amorphous silicon network (a-Si:H) of the second sub-layer 233B are hydrogen diluted so that a short-range-order (SRO) and a medium-range-order (MRO) are improved. In other words, as compared with a light absorbing layer 233 formed of micro-crystalline silicon germanium single film, hydrogenated micro-crystalline silicon of the second sub-layer 233B occupies spaces between hydrogenated micro-crystalline silicon germaniums of the first sub-layer 233A. Thus, a deposition rate is rapid and the light absorbing layer's defect density caused by germanium can be prevented from being increased.

As described above, the second sub-layer 233B is made of hydrogenated micro-crystalline silicon and the first sub-layer 233A is made of hydrogenated micro-crystalline silicon germanium. Here, as described in the embodiment of the present invention, the flow rate of the hydrogen varies in accordance with the deposition time as shown in Figs. 5A to 5C for the purpose of causing an incubation layer to be formed prior to the hydrogenated micro-crystalline silicon to be as thin as possible.

In other words, an incubation layer made of amorphous silicon is formed during the process of forming the hydrogenated micro-crystalline silicon. Since the amorphous silicon increases a recombination rate of a carrier and decreases the efficiency, the incubation layer should be as thin as possible. The more the flow rate of the hydrogen increases, the crystalline increases. In the embodiment of the present invention, the flow rate of hydrogen at a first point of time is greater than that of the hydrogen at a second point of time posterior to the first point of time. Accordingly, the thickness of the incubation layer is reduced, increasing the efficiency of the photovoltaic device.

Additionally, as shown in Figs. 5E to 5F, the first flow rate value α of the source gas including non-silicon based material such as germanium or the duration time t1 of the first flow rate value α increase in accordance with the elapse of the deposition time T. The first sub-layers 233A and the second sub-layers 233B, which are formed in accordance with the first flow rate value α and the second flow rate value β, of the light absorbing layer 233 are formed far from a side of incident light. Therefore, the farther the first and the second sub-layers 233a and 233B are from a side of incident light, the smaller the optical band gap of the first and the second sub-layers 233a and 233B gradually are.

Light with a particular wavelength having a high energy density has a small penetration depth. A larger optical band gap is required to absorb light with a particular wavelength having a high energy density.

Therefore, the lower flow rate the source gas including non-silicon based material such as germanium has, the more the optical band gap is. As shown in Figs. 5D to 5F, the sub-layers 233A and 233B closer to a side of incident light have a relatively larger optical band gap by the supplied source gas. As a result, the sub-layers 233A and 233B closer to a side of incident light absorb light with a particular wavelength as much as possible.

Also, the larger flow rate the source gas including non-silicon based material such as germanium has, the relatively smaller optical band gap the sub-layers 233A and 233B farther from a side of incident light have. As a result, the sub-layers 233A and 233B farther from a side of incident light absorb light with a wavelength other than the particular wavelength mentioned above as much as possible.

In the plasma-enhanced chemical vapor deposition method used in the embodiment of the present invention, a frequency of a voltage supplied from an electric power source E can be equal to or more than 13.56 MHz. When a frequency of a voltage supplied from an electric power source E is equal to or more than 27.12 MHz, a deposition rate is improved. As a result, the incubation layer made of the amorphous silicon can be thinner.

In order to absorb light with a long wavelength, an optical band gap of the light absorbing layer 233 made of hydrogenated micro-crystalline silicon germanium and hydrogenated micro-crystalline silicon can be equal to or more than 0.9eV and equal to or less than 1.3eV. An average germanium content of the light absorbing layer 233 can be is greater than 0 atomic % and equal to or less than 15 atomic %.

A thickness of the light absorbing layer 233 made of hydrogenated micro-crystalline silicon germanium and hydrogenated micro-crystalline silicon can be equal to or more than 0.5µm and equal to or less than 1.0µm. If the thickness of the light absorbing layer 233 is less than 0.5µm, the light absorbing layer 233 cannot perform its functions. If more than 1.0 µm, the thickness is so large that its efficiency is reduced.

That is, since the optical band gap of the light absorbing layer 233 in accordance with the embodiment of the present invention is as small as equal to or more than 0.9 eV and equal to or less than 1.3 eV, the light absorbing layer 233 can easily absorb light with a long wavelength even though the light absorbing layer 233 is as thin as equal to or more than 0.5 µm and equal to or less than 1.0 µm.

In addition, in order to form the optical band gap equal to or more than 0.9 eV and equal to or less than 1.3 eV, a content of non-silicon based material such as germanium should be increased. If a content of germanium increases, a deposition rate decreases and a tact time considerably increases. In the embodiment of the present invention, the second sub-layer 233B is alternately formed without supplying germanium. Therefore, it is possible to form an optical band gap equal to or more than 0.9 eV and equal to or less than 1.3 eV, even if an average germanium content is greater than 0 atomic % and equal to or less than 15 atomic %.

A thickness of the second sub-layer 233B made of hydrogenated micro-crystalline silicon can be equal to or more than 20nm. If the thickness of the second sub-layer 233B is less than 20nm, it is difficult to form the hydrogenated micro-crystalline silicon. Thus, it is hard to obtain the effect of the light absorbing layer 233 including the first and the second sub-layers 233A and 233B.

As described above, the thickness of the light absorbing layer 233 can be equal to or more than 0.5µm and equal to or less than 1.0µm. Also, a period of time equal to or more than 5 cycles P and equal to or less than 10 cycles P may be required in order that the light absorbing layer 233 including the first and the second sub-layers 233A and 233B can fully perform its functions. Therefore, when germanium with the first flow rate value α and the second flow rate value β (equal to 0) is supplied to the chamber during one cycle P, a sum of the thickness of the first sub-layer 233A and the thickness of the sub-layer 233B can be equal to or more than 50nm and equal to or less than 100nm.

An average crystal volume fraction of the light absorbing layer 233 made of hydrogenated micro-crystalline silicon germanium and hydrogenated micro-crystalline silicon can be equal to or more than 30% and equal to or less than 60%. If the average crystal volume fraction is less than 30%, amorphous silicon is generated a lot and carriers are increasingly recombined with each other, thereby reducing the efficiency. If the average crystal volume fraction is more than 60%, a volume of grain boundary in a crystalline material is increased and a crystal defect is increased, thereby increasing the recombination of carriers.

An average oxygen content of the light absorbing layer 233 made of hydrogenated micro-crystalline silicon germanium and hydrogenated micro-crystalline silicon can be equal to or less than 1.0 × 10²⁰ atoms/cm³. If the average oxygen content of the light absorbing layer 233 is more than 1.0 × 10²⁰ atoms/cm³, a conversion efficiency is reduced.

While the first sub-layer 233A is formed first in the embodiment of the present invention, the second sub-layer 233B can be formed prior to the first sub-layer 233A.

The foregoing embodiments and advantages are merely exemplary and are not to be construed as limiting the present invention. The present teaching can be readily applied to other types of apparatuses. The description of the foregoing embodiments is intended to be illustrative, and not to limit the scope of the claims. Many alternatives, modifications, and variations will be apparent to those skilled in the art. In the claims, means-plus-function clauses are intended to cover the structures described herein as performing the recited function and not only structural equivalents but also equivalent structures. Moreover, unless the term "means" is explicitly recited in a limitation of the claims, such limitation is not intended to be interpreted under 35 USC 112(6).

## Claims

1. A photovoltaic device comprising:
a substrate 100;
a first electrode 210 disposed on the substrate 100;
at least one photoelectric transformation layer 230 disposed on the first electrode 210, the photoelectric transformation layer comprising a light absorbing layer 233; and
a second electrode 250 disposed on the photoelectric transformation layer 230,
wherein the light absorbing layer 233 comprises the first sub-layer 233A and the second sub-layer 233B, the first sub-layer 233A comprising hydrogenated micro-crystalline silicon germanium (µc-SiGe:H) and an amorphous silicon germanium network (a-SiGe:H) formed among the hydrogenated micro-crystalline silicon germaniums, the second sub-layer 233B comprising hydrogenated micro-crystalline silicon (µc-Si:H) and an amorphous silicon network (a-Si:H) formed among the hydrogenated micro-crystalline silicons.

2. The photovoltaic device of claim 1, wherein an average germanium content of the light absorbing layer is greater than 0 atomic % and equal to or less than 15 atomic %.

3. The photovoltaic device of claim 1, wherein a thickness of the light absorbing layer is equal to or more than 0.5 µm and equal to or less than 1.0 µm.

4. The photovoltaic device of claim 1, wherein an average crystal volume fraction of the light absorbing layer is equal to or more than 30% and equal to or less than 60%.

5. The photovoltaic device of claim 1, wherein an average oxygen content of the light absorbing layer is equal to or less than 1.0 x 10²⁰ atoms/cm³.

6. The photovoltaic device of claim 1, wherein the photoelectric transformation layer 230 comprises a first photoelectric transformation layer 230-1 and a second photoelectric transformation layer 230-2 disposed on the first photoelectric transformation layer 230-1, and wherein the light absorbing layer comprises a first sub-layer 233-2A and a second sub-layer 233-2B, the first sub-layer comprising hydrogenated micro-crystalline silicon germanium (µc-SiGe:H) and an amorphous silicon germanium network (a-SiGe:H) formed among the hydrogenated micro-crystalline silicon germaniums, the second sub-layer comprising hydrogenated micro-crystalline silicon (µc-Si:H) and an amorphous silicon network (a-Si:H) formed among the hydrogenated micro-crystalline silicons.

7. The photovoltaic device of claim 6, wherein the second photoelectric transformation layer is farther away than the first photoelectric transformation layer from the viewpoint of a side of incident light.

8. The photovoltaic device of claim 1 to 6, wherein the amorphous silicon germanium network and the amorphous silicon network comprise crystalline silicon grains respectively.

9. A method of manufacturing a photovoltaic device, the method comprising:
forming a first electrode on a substrate;
forming at least one photoelectric transformation layer on the first electrode in a chamber, the photoelectric transformation layer comprising a light absorbing layer;
forming a second electrode on the photoelectric transformation layer;
wherein flow rates of silane which are supplied to the chamber are constant while the light absorbing layer is formed; and
wherein a flow rate of source gas comprising non-silicon based material varies alternately within a range between a first flow rate value and a second flow rate value in accordance with an elapse of a deposition time; and
wherein a flow rate of hydrogen flown to the chamber at a first point of time is greater than a flow rate of the hydrogen at a second point of time posterior to the first point of time.

10. The method of claim 9, wherein the first flow rate value increases in accordance with an elapse of a deposition time; and
wherein first sub-layers and second sub-layers of the light absorbing layer are formed far from a side of incident light, the first sub-layers and the second sub-layers being formed in accordance with the first flow rate value and the second flow rate value.

11. The method of claim 9, wherein a duration time of the first flow rate value increases in accordance with an elapse of a deposition time; and
wherein first sub-layers and second sub-layers of the light absorbing layer are formed far from a side of incident light, the first sub-layers and the second sub-layers being formed in accordance with the first flow rate value and the second flow rate value.

12. The method of claims 9 to 11, wherein the second flow rate value is 0.

13. The method of claim 9, wherein the non-silicon based material corresponds to germanium.

14. The method of claims 9 to 11, wherein the flow rate of the hydrogen, which is supplied during at least one cycle derived from a sum of a duration time of the first flow rate value and a duration time of the second flow rate value, is greater than the flow rate of hydrogen which is supplied after the at least one cycle.

15. The method of claims 9 to 11, wherein the flow rate of hydrogen is reduced for each cycle derived from a sum of a duration time of the first flow rate value and a duration time of the second flow rate value.

16. The method of claims 9 to 11, wherein the flow rate of hydrogen is gradually reduced in accordance with the elapse of the deposition time.

17. The method of claims 9 to 11, wherein the light absorbing layer comprises a plurality of the first sub-layers and the second sub-layers, and wherein the first sub-layers and the second sub-layers closer to a side of incident light have a larger optical band gap.

18. The method of claim 9, wherein, when the source gas comprising the non-silicon based material comprises germanium, an average germanium content of the light absorbing layer is equal to or more than 0 atomic % and equal to or less than 15 atomic %.

19. The method of claims 9 to 11, wherein an optical band gap of the light absorbing layer is equal to or more than 0.9 eV and equal to or less than 1.3 eV.

20. The method of claims 9 to 11, wherein a frequency of a voltage supplied to the chamber while the light absorbing layer is formed is equal to or more than 27.12 MHz.

21. The method of claim 9, wherein the source gas comprising the non-silicon based material comprises germanium, and wherein the light absorbing layer comprises the first sub-layer and the second sub-layer, the first sub-layer being formed while the source gas with the first flow rate value is supplied, and the second sub-layer being formed while the source gas with the second flow rate value is supplied, and wherein the second sub-layer is formed of hydrogenated micro-crystalline silicon, and wherein the first sub-layer is formed of hydrogenated micro-crystalline silicon germanium.

22. The method of claims 9 to 11, wherein a thickness of the light absorbing layer is equal to or more than 0.5 µm and equal to or less than 1.0 µm.

23. The method of claims 9 to 11, wherein the light absorbing layer comprises the first sub-layer and the second sub-layer, the first sub-layer being formed while the source gas with the first flow rate value is supplied, and the second sub-layer being formed while the source gas with the second flow rate value is supplied, and wherein a thickness of the second sub-layer is equal to or more than 20 nm.

24. The method of claims 9 to 11, wherein the light absorbing layer comprises the first sub-layer and the second sub-layer, the first sub-layer being formed while the source gas with the first flow rate value is supplied, and the second sub-layer being formed while the source gas with the second flow rate value is supplied, and wherein, during one cycle derived from a sum of a duration time of the first flow rate value and a duration time of the second flow rate value, a sum of a thickness of the first sub-layer and a thickness of the sub-layer is equal to or more than 50nm and equal to or less than 100nm.

25. The method of claim 9, wherein the source gas comprising the non-silicon based material comprises germanium, and wherein the first flow rate value is greater than the second flow rate value and the second flow rate value has a value of 0, and wherein an average crystal volume fraction of the light absorbing layer is equal to or more than 30% and equal to or less than 60%.

26. The method of claims 9 to 11, wherein an average oxygen content the light absorbing layer is equal to or less than 1.0 × 10²⁰ atoms/cm³.
